# EUROPEAN PATENT SPECIFICATION

(11) **EP 0 460 775 B1**
(45) Date of publication and mention of the grant of the patent: **02.08.1995**
(21) Application number: 91202141.7
(22) Date of filing: 23.12.1987
(51) Int. Cl.: G11C 27/02, H03F 1/30, H03K 5/153

(54) **A circuit for providing a pulsed output signal from three binary input signals**
Schaltung zur Erzeugung eines pulsförmigen Ausgangssignales aus drei binären Eingangssignalen
Circuit fournissant un signal impulsionnel de sortie à partir de trois signaux d'entrée binaires

(30) Priority: 27.02.1987 US 20289
(43) Date of publication of application: 11.12.1991
(62) Divisional of application: 87311386.4
(73) Proprietor: SEAGATE TECHNOLOGY INTERNATIONAL, Georgetown Grand Cayman Island (KY)
(72) Inventor: Janz, Donald Walter, Oklahoma City, OK 73132 (US)
(74) Representative: Sturt, Clifford Mark

(56) References cited:
- EP-A- 0 094 314
- EP-A- 0 142 161
- EP-A- 0 165 553
- EP-A- 0 176 596
- EP-A- 0 194 641
- US-A- 4 238 809
- US-A- 4 418 305

## Description

This invention relates to a circuit for providing a pulsed output signal from three binary input signals. The present invention is particularly useful as part of a servo system for a disc drive.

This specification assumes some familiarity with the construction of magnetic disk drive data storage systems and means for generating and using servo information from coded information on the disk media but its teaching can be applied to analogous art as well.

In EP-A-0 165 553, there is disclosed a sample and hold circuit for deglitching the output of a digital-to-analog converter, in which the circuit has two signal paths. One signal path couples the input signal to an output amplifier to track the input signal during a sample phase. The other signal path couples the input signal through an amplifier to a storage capacitor during the sample phase. A timing circuit operates a switch at the end of the sample phase to begin a hold phase during which the output amplifier is decoupled from the input signal and coupled to the storage capacitor, whilst the storage capacitor is decoupled from the buffer amplifier.

EP-A-0 142 161 discloses an apparatus processing EKG signals. A pace pulse in the input signal is prevented from reaching the output by providing a substitute pulse in its place.

According to the present invention, there is provided a circuit for providing a pulsed output signal (RESET SIGNAL) from three binary input signals (BIT 2, BIT 0, BIT 1), the circuit comprising:
means for inverting each of said binary input signals (BIT 2, BIT 0, BIT 1);
a first NOR gate (N1) having as its inputs the inverse of a first (BIT 2) of said binary signals and a third (BIT 1) of said binary signals;
a second NOR gate (N2) having as its inputs the first (BIT 2) of said binary signals and the inverse of a second (BIT 0) of said binary signals;
a third NOR gate (N3) having as its inputs the second (BIT 0) of said binary input signals and the inverse of the third (BIT 1) of said binary signals;
first, second and third flip flops (F4, F5, F6) which receive as their respective clock inputs the output of the first, second and third NOR gates (N1, N2, N3), the D inputs of each of the flip-flops being tied to a "high" voltage level;
a first NAND gate (NA1) having as its inputs the respective Q̅ outputs of each of said flip-flops (F4, F5, F6);
means for inverting the output of said NAND gate (NA1);
the fourth flip-flop (F7) having as its C̅L̅E̅A̅R̅ input the inverse of the output of said first NAND gate (NA1) and as its clock input a first clock pulse (CLOCK 1), and providing at its Q output the pulsed output signal (RESET SIGNAL);
a fourth NOR gate (N4) having as its inputs the Q output of said fourth flip-flop (F7) and the inverse of a delayed second clock signal (CLOCK 2);
a fifth flip-flop (F8) having as its clock input the output of said fourth NOR gate, as its C̅L̅E̅A̅R̅ input the inverse of the output of said first NAND gate (NA1) and as its D input the "high" voltage level, and having its Q output applied to the D input of said fourth flip-flop (F7); and
a second NAND gate (NA2) having as its inputs said delayed second clock signal (CLOCK 2), the Q̅ output of said fifth flip-flop (F8), the Q̅ output of said fourth flip-flop (F7) and the output of said first NAND gate (NA1), and having its output applied to the C̅L̅E̅A̅R̅ input of each of the first, second and third flip-flops (F4, F5, F6).

Further, optional, features of the invention are defined in appended claims 2 to 8.

The circuit may provide a pulsed output voltage signal which is the differential of the voltage of an input signal and may have particular application to deriving such signals for driving servo-mechanisms where the unprocessed signals contain undesirable portions. The circuit may be particularly useful for signals in which a desired portion of the signal contains a leg of relatively mild scope and a rapid leg of relatively large opposite scope and has particular application to deriving usful velocity information from "tri-phase servo patterns".

Preferably, the means for maintaining the voltage includes active circuit means coupled between the holding capacitor and the node, the active circuit means having a high impedance input connected to the holding capacitor, whereby the node can be maintained at the voltage V_{H} without discharging the holding capacitor. Conveniently, the active circuit means is an operational amplifier.

An inverting amplifier may be coupled between the output of the active circuit means and the circuit node and to another input of the active circuit means.

Advantageously, switch means is connected to the active circuit means and arranged so that, in operation, an output of the active circuit means is switched from the holding capacitor to the circuit node in response to the reset signal.

The circuit may have switch means having an input connected to an output of the active means, a normally closed first output connected to the holding capacitor and a normally open second output connected through an inverting amplifier both to another input of the active circuit means and to the node.

The invention is illustrated, merely by way of example, in the accompanying drawings, in which:-
Figure 1 is a simplified diagram of one embodiment of a circuit for removing unwanted temporal portions of a voltage varying signal;
Figure 1A is a detailed diagram of the circuit of Figure 1;
Figure 2 is a graph with a set of voltage signals with respect to time to illustrate the operation of the circuit of Figure 1;
Figure 3 is a diagram of a typical practical differentiator;
Figure 4 is a graph of a non-ideal input signal to the circuit of Figure 1;
Figure 5 is a graph of a possible ideal output signal from the circuit of Figure 1;
Figure 6 is a diagram of a circuit for deriving a reset signal from the tri-phase servo pattern for the circuit of Figure 1;
Figure 7 is a graph of three signals, pairs of which are related to the circuit of Figure 6;
Figure 8 is a graph of an output signal of the circuit of Figure 6;
Figure 9 is a schematic diagram of a circuit for deriving a reset signal for the circuit of Figure 1; and
Figure 10 is a timing diagram for use with Figure 9.

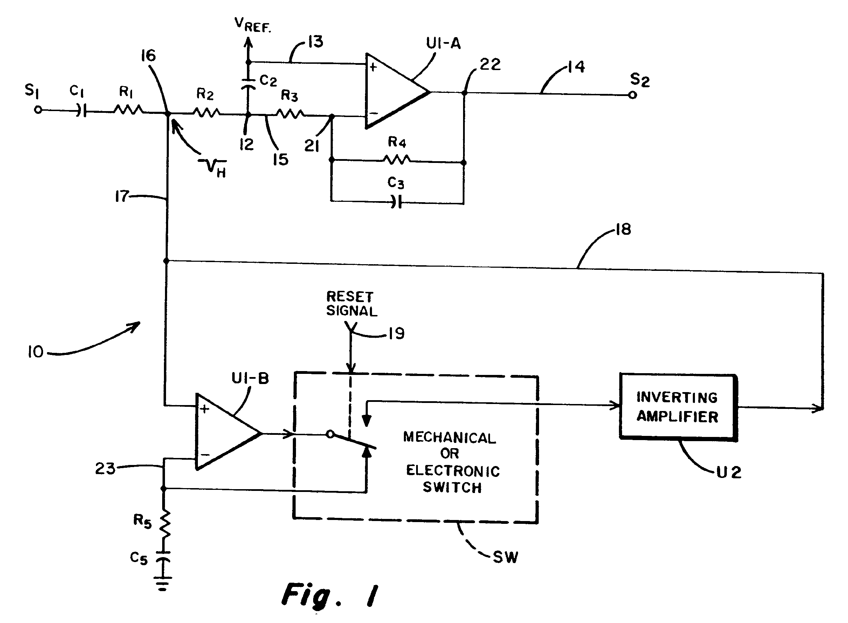

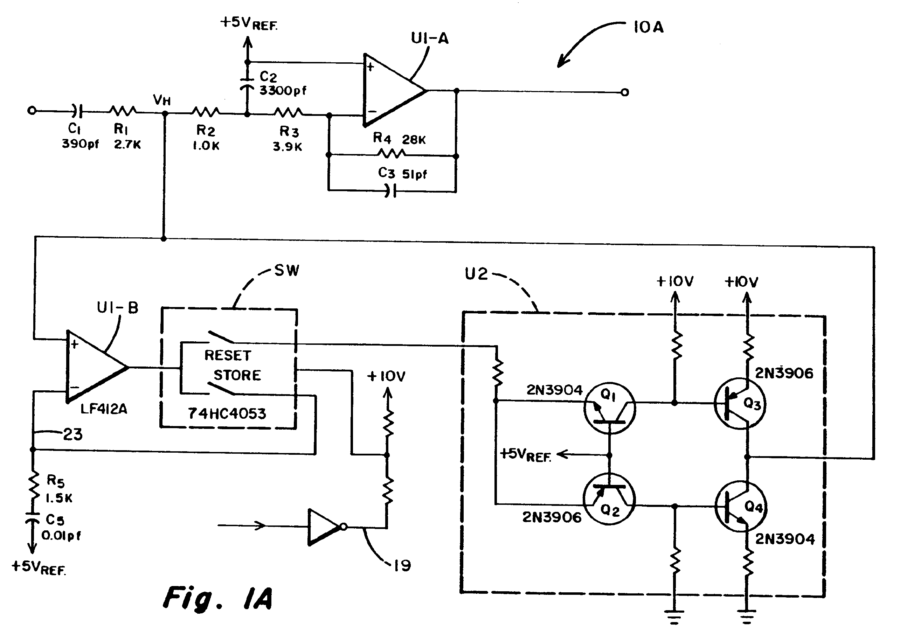

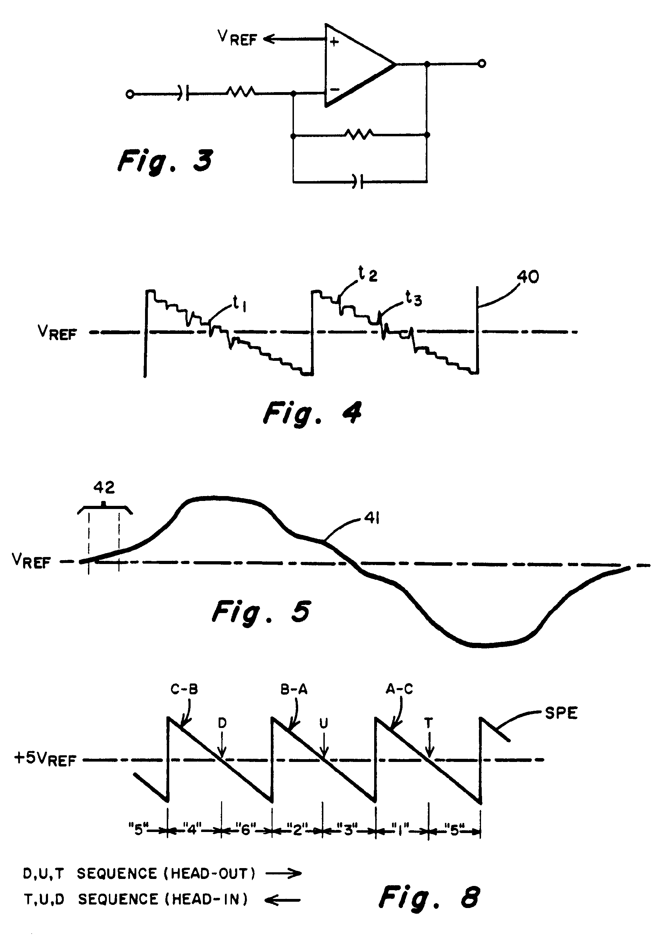

Figure 1 is a simplified diagram of a circuit 10 for removing unwanted temporal portions of a voltage varying signal. The term "line" used herein is to denote electrical connection via wire or other means. An input signal is provided to the circuit 10 at a point S1 charging a capacitor C1 and thence through resistors R1, R2, R3 to a negative input of an operational amplifier U1-A. The line between the resistor R3 and the negative input to the operational amplifier U1-A is also linked to a resistor R4 and a capacitor C3 which are connected in parallel between a point 21 (on the line between the resistor R3 and the negative input) and a point 22 on a line 14. Thus the combination of the operational amplifier U1-A, the resistor R4 and the capacitor C3 constitutes a differentiator as shown in Figure 3. The line 14 is the output of the operational amplifier U1-A provided as output from the circuit 10 at a point S2. A positive input line 13 to the operational amplifier U1-A provides a reference voltage and is connected across a capacitor C2 to a point 12 on a signal input line 15 between resistors R2 and R3. Between resistors R1, R2 on the signal input line, point 16 connects a line 17 to the positive input of an operational amplifier U1-B. The line 17 is also connected to a line 18. The negative input of the operational amplifier U1-B is connected to ground (GND) through a resistor R5 and a capacitor C5 on a line 23. The output of the operational amplifier U1-B is selectively connected between: (a) a point on the line 23 between the negative input to the operational amplifier U1-B and the resistor R5, and (b) an approximate minus one or inverting amplifier U2. The selection is governed by a reset signal provided on a line 19 to a mechanical or electronic switch SW. On the occurrence of a reset signal on the line 19, the switch SW directs the output of the operational amplifier U1-B to the inverting amplifier U2. The output of the inverting amplifier U2 is to the line 18 connected by the line 17 to the point or circuit node 16. After the reset signal indicates that the reset is no longer occurring, the switch is set to provide the output of the operational amplifier U1-B to the line 23.

The input signal charges the capacitor C1 and provides a voltage level V_{H} at a point 16 which represents the charging current through the capacitor C1. Referring briefly to Figure 3, it will be noted that the resistors R2, R3 and the capacitor C2 are additions to this circuit which are not found in a typical practical differentiator of Figure 3.

Note that the operational amplifier U1-A connected as shown will tend to stabilise itself at a point where the voltage on the negative input is brought up to a voltage level V_{REF} on the positive input. Therefore, the output voltage of the operational amplifier U1-A will tend to be proportional to the voltage level V_{H}. It should be recognised that because the changes in the voltage level V_{H} may be small (about 0.1 millivolt) any ambient current leakage will affect the circuit performance. This fact must be considered in component choice.

The voltage level V_{H} on the line 17 is provided as a positive input to the operational amplifier U1-B. During normal operation of the circuit 10 when the wanted portion of the signal is provided as the input signal to the point S1 and no reset signal is present on the line 19, the output of the operational amplifier U1-B is provided to the line 23 as input to the negative input of the operational amplifier U1-B and through the resistor R5 to the capacitor C5 to ground, or as in a preferred embodiment, may employ a 5 volt reference in place of ground. The resistor R5 can provide filtering to the voltage provided to the capacitor C5 if desired. On the occurrence of a reset signal, the switch SW transfers the output of the operational amplifier U1-B to the amplifier U2. Thus the voltage level on the capacitor C5 provides an error voltage to the amplifier U2 which provides a voltage level equal to the voltage level on the capacitor C5 on the line 18 to the line 17 and to the point 16, thus sustaining the voltage level to the negative input of the operational amplifier U1-A during the reset interval.

A more detailed schematic diagram of the circuit of Figure 1 is provided in Figure 1A in which the resistance and capacitance values are provided and reference made to standard industrial use numbers for designating particular integrated circuit and other component parts.

Referring now to Figure 1A the circuit is indicated by reference numeral 10A. Resistance, capacitance and voltage values may be varied in accordance with known principles. Certain characteristics of some of the component parts shown, however, are important to prevent problems with ambient voltage affecting the performance of the differentiation characteristics of the operational amplifier U1-A. For instance, the amplifier U2 comprises a low leakage, high output impedance inverter amplifier when not operating, so transistors Q3, Q4, for instance, must be low leakage transistors. The numbers 2N3906 and 2N3904 designate transistors of this type. Transistors Q1 and Q2 need not be low leakage transistors. Likewise, the operational amplifier U1-B, designated by the industry standard number LF412A (currently available through National Semiconductor Corporation) is a high speed operational amplifier with high input impedance (100 pico amp input), which will have no leakage current to affect the operation of the operational amplifier U1-A, which most likely will be on the same circuit board.

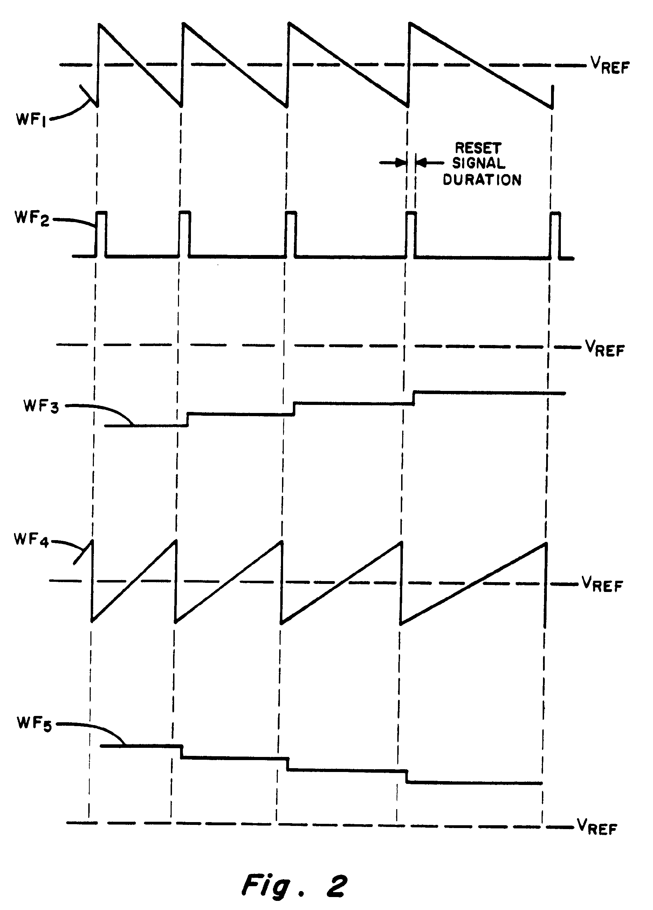

Figure 4 illustrates a small segment of a possible non-ideal input signal 40. This signal will correspond to some portion of a signal WF₁ whose waveform is shown in Figure 2. Because this signal is originally generated by digital circuits, it takes on a stairstep form as shown. Due probably primarily to irregularities on the date disk itself, transients or spikes t₁, t₂, t₃ will often be found in the non-ideal input signal. These transients, as well as the stairstep configuration of the input signal 40, will be smoothed and filtered out by the circuit of Figure 1. The input signal 40 is indicated with reference to the voltage level V_{REF} in Figure 4.

It must be noted that the reference voltage levels need not be the same DC potential for any of the three points to which they are introduced into the circuit but the potential values must be constant. A reference voltage level of 5 volts for the positive input of the operational amplifier was found to be best in practice to achieve the greatest dynamic range for the power supplies used.

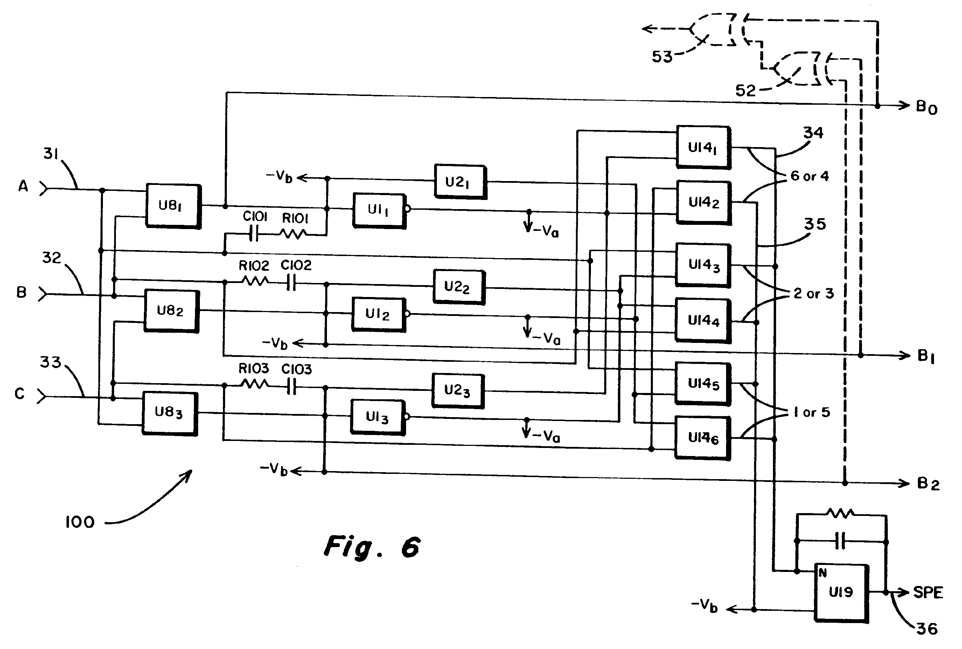

Figure 5 describes by a curve 41 a possible ideal output signal. Segment 42 corresponds to a negative output signal portion indicated by signal WF₃ in Figure 2.

There are five waveforms illustrated in Figure 2, namely:
WF₁, an input signal with a negative going slope with a positive slope transition;
WF₂, a reset signal consisting of a series of pulses indicating the time period for the slope transistion;
WF₃, a negative output signal provided at the point S2 for the input signal WF₁;
WF₄, an input signal of positive slope and its corresponding output for a positive output WF₅; and
WF₅, a positive output signal provided at the point for the signal WF₄.

All these waveform signals occur over the same length of time and the voltage value is plotted against the voltage reference level V_{REF}. Signals WF₁, WF₂, WF₃ may occur concurrently, and signals WF₄, WF₅, WF₂ may also occur concurrently, using a circuit according to the present invention.

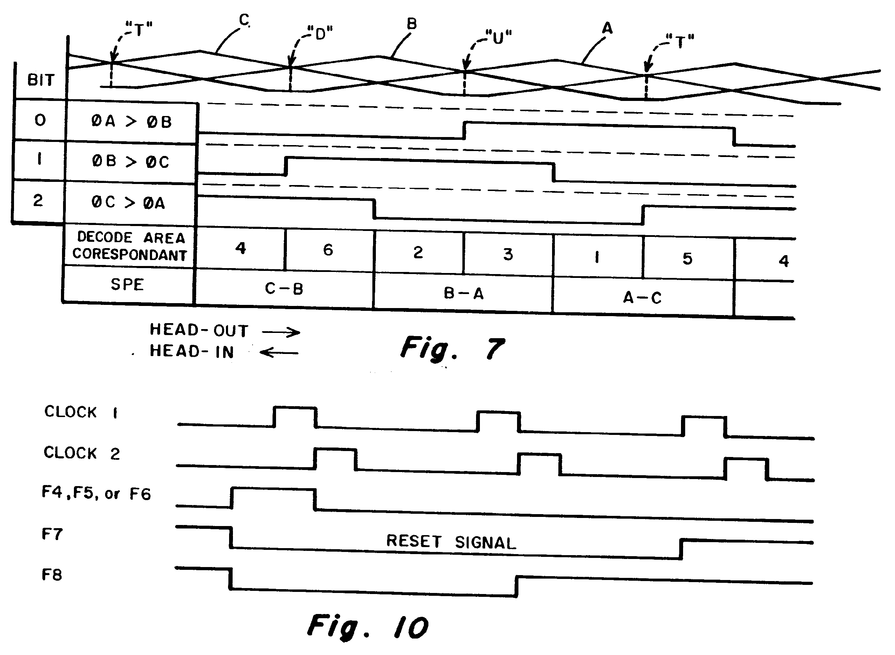

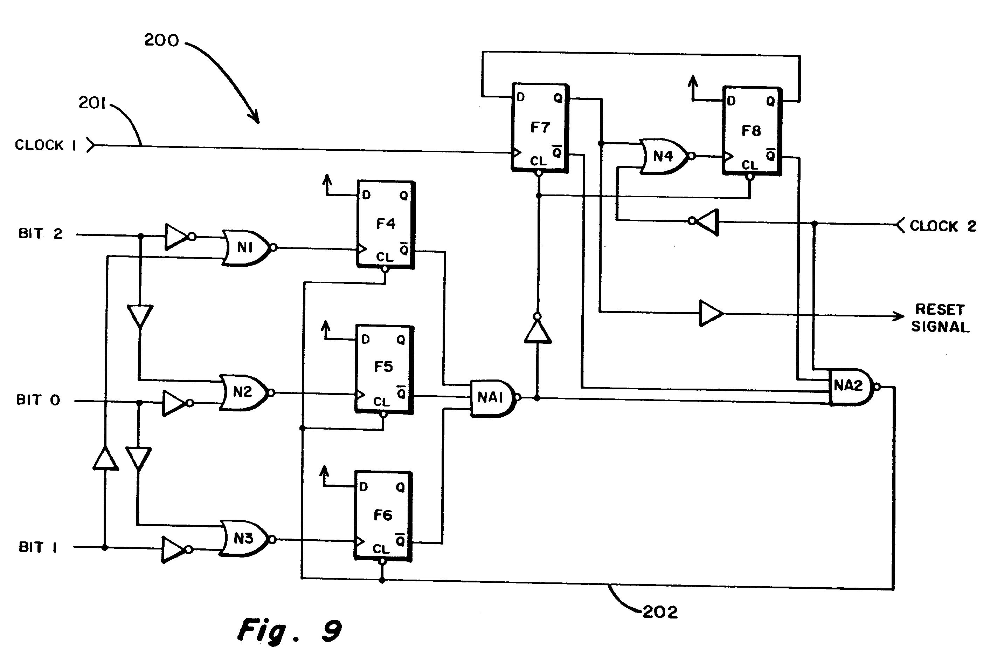

Referring now to Figure 6 there is shown a circuit diagram of a circuit 100 through which the reset signal may be derived from tri-phase signals. Three triangle wave signals A, B, C are provided on lines 31, 32, 33, respectively. The triangle waves are derived from tri-phase spaced signals located in a formatted data disk. The circuit 100 of Figure 6 provides an output signal from line 36 which forms the signal input at the point S1 of the circuit 10 of Figures 1 and 1A. A detailed representation of this output signal is found in Figure 8 and of the signals A, B, C is found at the top of Figure 7.

Note that in Figure 7, three "bit" signals 0, 1 and 2 (square wave signals or digital "pulses") are shown in their radial relation to the signals A, B, C which occur at the same time and radial position. These bit signals 0, 1 and 2 can be found on output lines B₀, B₁, B₂ of the circuit 100 respectively. The negative going slope of each one of these three signals produces a reset signal of a finite duration. This is preferably accomplished with a micro-processor decode circuit of the three bit signals or, if only generating reset signals during "head-in" (i.e., the head moving towards the centre of the disk) is acceptable, two EXCLUSIVE-OR gates such as gates 52, 53 arranged and connected as shown can be used. A preferred decode circuit is explained with reference to Figure 9, which generates a reset signal during rapid transition periods in the servo position error signal, but other constructions to accomplish this are possible. The bit signals used to generate the reset signal are produced by the circuit 100 which acts in the following manner.

The three phase signals A, B, C are compared by three comparators U8₁, U8₂, U8₃. Where the signal A on the line 31 is of higher voltage than the signal B on the line 32, the output of a non-inverting buffer circuit U2₁ is "high" and the output of an inverting circuit U1₁ is "low". Otherwise, the reverse is the case. The two other comparators U8₂, U8₃ and their associated inverting circuits U1₂, U1₃ and non-inverting buffer circuits U2₂, U2₃ function in the same way for their inputs.

The signals A, B, C are input into the circuit 100 on lines 31, 32 and 33 respectively. In Figure 7 typical signals A, B and C are shown with respect to a reference voltage level V_{REF}. Each of the signals A, B, C is fed into the positive input of a respective one of the comparators U8₁, U8₂, U8₃. One of the other of the three signals A, B, C is input into the negative input of each of the comparators. "LM339" is the industry standard numerical designation for comparators used in a preferred embodiment and they are currently available from National Semiconductor Corporation.

Each of the signals A, B, C is also input to two of six analog switches U14₍₁₋₆₎ to be passed through to inverting and non-inverting differential amplifier input lines 34, 35, respectively, to create the servo position error signal SPE on line 36 as shown in Figures 7 and 8.

The signals A, B and C input to the comparators U8₁, U8₂, U8₃ in turn drive the inverting circuits U1₁, U1₂, U1₃, and also drive the non-inverting buffer circuits U2₁, U2₂, U2₃. The outputs of these circuits provide the proper switching of the analog switches U14₍₁₋₆₎.

Resistance/capacitor pairs 101, 102, 103 provide hysteresis to the respective comparators U8₁, U8₂, U8₃ to prevent multiple switching during noise transients which may appear in the signals A, B, C.

A differential amplifier U19 provides a signal on the line 36 as shown in Figure 8. The alpanumeric indicators attached to the signal shown in Figure 8 (for "head-in" sequence) correspond to the decimal or SPE indicators shown in Figure 7.

The bit signals of the comparators produced on the output lines B1, B2, BO, are shown in Figures 7 as 0, 1 and 2. Therefore, looking at the signals in a "head-in" direction in Figure 7, because the transition or unwanted signal portion occurs between areas designated 2 and 6, areas designated 1 and 3 and areas designated 4 and 5 (see Figure 8 and bottom of Figure 7) and because a downward going pulse occurs at each one of these area interfaces and because only one of the three bit signals is "high" at a downward going signal area, all that is necessary is to fire a reset signal at a downward going pulse. In a "head-out" direction each upward going pulse will signal that a reset signal is necessary; i.e., that the slope transition occurs at that interface. A microprocessor could receive these digital bit signals as input and based on a program generate a reset pulse at the proper upward or onward going transitions of each of the bit signals. It is simplest and most efficient to think of this in terms of two EXCLUSIVE-OR gates 52, 53 (Figure 6 ) which will provide an output pulse of relatively short duration in conjunction with a digital one shot for each of the indicated transistors.

The decode of the bit signals 0, 1, 2 is accomplished with the equivalent of three AND gates with an output each to one of three flip-flops whose outputs are OR'd together. The output of this OR would be the reset signal for both "head-in" and "head-out" orientations. In practice the reset signal generation is more complicated and is explained with reference to Figure 9, where a circuit 200 to accomplish this is shown. However, it should be noted that other decode schemes are possible and that reset signals may come from signals other than the tri-phase servo signals of this embodiment.

In Figure 9, a clock input, which is a period length smaller than the desired duration of the reset signal, is provided to the circuit 200 at an input 201. The clock pulse should be a short portion of the clock period. The clock pulse (clock 1 in Figure 10) is provided as the clock input to a flip-flop F7. A second clock (clock 2 in Figure 10) provides a delayed clock to a NAND gate NA2, and its inverse is provided to a NOR gate N4. The Q output of the flip-flop F7 when "low" provides the reset signal used in the circuits 10 and 10A to control the switch SW.

The circuit 200 receives the three bit signals from the circuit 100 of Figure 6 (shown in time relation to each other in Figure 7) as inputs. They are provided, inverted and non-inverted as inputs to NOR gates N1, N2, N3 respectively. The outputs of these NOR gates are input to respective flip-flops F4, F5, F6. The Q̅ output of these flip-flops is input to NAND gate NA1 whose output is provided as an input to the NAND gate NA2. The output of the NAND gate NA1 clears the flip-flop F7. The NAND gate NA2 also receives the Q̅ output of the flip-flops F7, F8 as inputs. The output of the NAND gate NA2 provides a clear signal on line 202 to the flip-flops F4, F5, F6. The D inputs of the flip-flops F4, F5, F6, F8 are all tied to "high" signal or voltage level as indicated by arrows.

## Claims

1. A circuit for providing a pulsed output signal (RESET SIGNAL) from three binary input signals (BIT 2, BIT 0, BIT 1), the circuit comprising:
means for inverting each of said binary input signals (BIT 2, BIT 0, BIT 1);
a first NOR gate (NI) having as its inputs the inverse of a first (BIT 2) of said binary signals and a third (BIT 1) of said binary signals;
a second NOR gate (N2) having as its inputs the first (BIT 2) of said binary signals and the inverse of a second (BIT 0) of said binary signals;
a third NOR gate (N3) having as its inputs the second (BIT 0) of said binary input signals and the inverse of the third (BIT 1) of said binary signals;
first, second and third flip flops (F4, F5, F6) which receive as their respective clock inputs the output of the first, second and third NOR gates (N1, N2, N3), the D inputs of each of the flip-flops being tied to a "high" voltage level;
a first NAND gate (NA1) having as its inputs the respective Q̅ outputs of each of said flip-flops (F4, F5, F6);
means for inverting the output of said NAND gate (NA1);
a fourth flip-flop (F7) having as its C̅L̅E̅A̅R̅ input the inverse of the output of said first NAND gate (NA1) and as its clock input a first clock pulse (CLOCK 1), and providing at its Q output the pulsed output signal (RESET SIGNAL);
a fourth NOR gate (N4) having as its inputs the Q output of said fourth flip-flop (F7) and the inverse of a delayed second clock signal (CLOCK 2);
a fifth flip-flop (F8) having as its clock input the output of said fourth NOR gate, as its C̅L̅E̅A̅R̅ input the inverse of the output of said first NAND gate (NA1) and as its D input the "high" voltage level, and having its Q output applied to the D input of said fourth flip-flop (F7); and
a second NAND gate (NA2) having as its inputs said delayed second clock signal (CLOCK 2), the Q̅ output of said fifth flip-flop (F8), the Q̅ output of said fourth flip-flop (F7) and the output of said first NAND gate (NA1), and having its output applied to the C̅L̅E̅A̅R̅ input of each of the first, second and third flip-flops (F4, F5, F6).

2. A circuit as claimed in claim 1 for use in a servo system of a disc drive, including:
comparator means (U8₁-U8₃) having as its input three tri-phase spaced signals (A,B,C) derived from tri-phase servo patterns on a magnetic disc and producing a first output which is "high" if a first of said tri-phase spaced signals (A) is greater than a second (B), a second output which is "high" if the second of said tri-phase spaced signals (B) is greater than a third (C), and a third output which is "high" if the third of said tri-phase spaced signals (C) is greater than the first (A), the outputs otherwise being "low", the first, second and third outputs of the comparator means being applied to said circuit as the second (BIT O), third (BIT 1) and first (BIT 2) of said binary input signals respectively.

3. A circuit as claimed in claim 2 including means for generating a servo position error signal (SPE, S1) having a sawtooth waveform (WF₁, WF₄) from said tri-phase spaced signals (A,B,C), which comprises inverter means (U1₁-U1₃) for providing an inverted form of each of the outputs of the comparator means; first analogue switch means (U14₁) having as its inputs the second of said tri-phase spaced signals (B), the inverse of the first output of the comparator means and the third output of the comparator means; second analogue switch means (U14₂) having as its inputs the third of said tri-phase spaced signals (C), the inverse of the first output of the comparator means and the third output of the comparator means; third analogue switch means (U14₃) having as its inputs the first of said tri-phase spaced signals (A), the second output of the comparator means and the inverse of the third output of the comparator means; fourth analogue switch means (U14₄) having as its inputs the second output of said comparator means, the inverse of the third output of said comparator means and the second of said tri-phase spaced signals (B); fifth analogue switch means (U14₅) having as its inputs the first of said tri-phase spaced signals (A), the first output of said comparator means and the inverse of the second output of said comparator means; sixth analogue switch means (U14₆) having as its inputs the first output of the comparator means, the inverse of the second output of the comparator means and the third of said tri-phase spaced signals (C); differential amplifier means (U19) which receives as its inverting input the outputs of the first, third and sixth analogue switch means and which receives as its non-inverting input the outputs of the second, fourth and fifth of said analogue switch means, the output of the differential amplifier means providing the servo position error signal (SPE, S1).

4. A circuit as claimed in claim 3 in combination with a second circuit for providing as an output voltage signal (S2), for driving a servo mechanism of a disc drive, the differential of the servo position error signal (SPE, S1), which error signal includes unwanted temporal portions, the second circuit comprising:
an input capacitor (C1), one side of which receives said servo position error signal (SPE, S1) and the other side of which is connected to a circuit node (16) which is connected through at least one resistor (R2,R3) to an input terminal of an operational amplifier (U1-A) and to one end of a feedback resistor (R4) whose other end is connected to the output terminal of the operational amplifier (U1-A) and to an output line (14) for the output signal (S2);
means (U1-B) for storing the voltage VH at the circuit node (16) on a holding capacitor (C5); and
a switch (SW) responsive to said pulsed output signal for applying the voltage V_{H} at the holding capacitor (C5) to the node (16) for the duration of the pulses, the pulses coinciding with the part of the sawtooth waveform (WF₁, WF₄) of the servo position error signal (SPE, S1) having the highest rate of change, which parts of the waveform are said unwanted temporal portions.

5. A circuit as claimed in claim 4, characterised by comprising active circuit means (U1-B) coupled between the holding capacitor (C5) and the node (16), the active circuit means (U1-B) having a high impedance input connected to the holding capacitor (C5), whereby the node (16) can be maintained at the voltage V_{H} without discharging the holding capacitor.

6. A circuit as claimed in claim 5, characterised in that the active circuit means (U1-B) is an operational amplifier.

7. A circuit as claimed in claim 5 or 6, characterised by an inverting amplifier (U2) coupled between the output of the active circuit means (U1-B) and the circuit node (16) and to another input of the active circuit means (U1-B).

8. A circuit as claimed in claim 5, characterised in that the said means for storing the voltage V_{H} at the circuit node (16) on the holding capacitor (C5) comprises said active circuit means (U1-B).

## Patentansprüche

1. Schaltung zur Erzeugung eines impulsförmigen Ausgangssignals (RÜCKSETZSIGNAL) aus drei binären Eingangssignalen (BIT 2, BIT 0, BIT 1), wobei die Schaltung folgende Teile umfaßt:
Einrichtungen zur Invertierung jedes der binären Eingangssignale (BIT 2, BIT 0, BIT 1),
ein erstes NOR-Verknupfungsglied (N1), das als seine Eingänge den invertierten Wert eines ersten (BIT 2) der binären Signale und ein drittes (BIT 1) der binären Signale aufweist,
ein zweites NOR-Verknüpfungsglied (N2), das als seine Eingänge das erste (BIT 2) der binären Signale und den invertierten Wert eines zweiten (BIT 0) der binären Signale aufweist,
ein drittes NOR-Verknüpfungsglied (N3), das als seine Eingänge das zweite (BIT 0) der binären Eingangssignale und den invertierten Wert des dritten (BIT 1) der binären Signal aufweist,
erste, zweite und dritte Flip-Flop-Schaltungen (F4, F5, F6), die als ihre jeweiligen Takteingänge den Ausgang der ersten, zweiten und dritten NOR-Verknüpfungsglieder (N1, N2, N3) empfangen, wobei die D-Eingänge weder der Flip-Flop-Schaltungen mit einem 'hohen' Spannungspegel fest verbunden sind,
ein erstes NAND-Verknüpfungsglied (NA1), das als Eingänge die jeweiligen Q̅-Ausgänge jeder der Flip-Flop-Schaltungen (F4, F5, F6) aufweist,
Einrichtungen zur Invertierung des Ausganges des NAND-Verknüpfungsgliedes (NA1),
eine vierte Flip-Flop-Schaltung (F7), die als L̅Ö̅S̅C̅H̅-Eingang den invertierten Wert des Ausganges des ersten NAND-Verknüpfungsgliedes (NA1) und als ihren Takteingang einen ersten Taktimpuls (TAKT 1) aufweist und an ihrem Q-Ausgang das impulsförmige Ausgangssignal (RÜCKSETZSIGNAL) liefert,
ein viertes NOR-Verknüpfungsglied (N4), das als seine Eingänge den Q-Ausgang der vierten Flip-Flop-Schaltung (F7) und den invertierten Wert eines verzögerten zweiten Taktsignals (TAKT 2) aufweist,
eine fünfte Flip-Flop-Schaltung (F8), die als ihren Takteingang den Ausgang des vierten NOR-Verknüpfungsgliedes, als ihren L̅Ö̅S̅C̅H̅-Eingang den invertierten Wert des Ausganges des ersten NAND-Verknüpfungsgliedes (NA1) und als ihren DEingang den 'hohen' Spannungspegel aufweist, und deren Q-Ausgang dem D-Eingang der vierten Flip-Flop-Schaltung (F7) zugeführt wird, und
ein zweites NAND-Verknüpfungsglied (NA2), das als seine Eingänge das verzögerte zweite Taktsignal (TAKT 2), den Q̅-Ausgang der fünften Flip-Flop-Schaltung (F8), den Q̅-Ausgang der vierten Flip-Flop-Schaltung (F7) und den Ausgang des ersten NAND-Verknüpfungsgliedes (NA1) aufweist und dessen Ausgang dem L̅Ö̅S̅C̅H̅-Eingang jedes der ersten, zweiten und dritten Flip-Flop-Schaltungen (F4, F5, F6) zugeführt wird.

2. Schaltung nach Anspruch 1 zur Verwendung in einem Servosystem für ein Plattenlaufwerk, mit:
Vergleichereinrichtungen (U8₁-U8₃), die als Eingangssignale drei einen Abstand voneinander aufweisende, von Dreiphasen-Servomustern auf einer Magnetplatte abgeleitete Dreiphasen-Signale aufweisen und einen ersten Ausgang, der 'hoch' ist, wenn ein erstes der einen Abstand aufweisenden Dreiphasen-Signale (A) größer als ein zweites Signal (B) ist, einen zweiten Ausgang, der 'hoch' ist, wenn das zweite der einen Abstand aufweisenden Dreiphasen-Signale (B) größer als ein drittes Signal (C) ist, und einen dritten Ausgang erzeugen, der 'hoch' ist, wenn das dritte der einen Abstand aufweisenden Dreiphasen-Signale (C) größer als das erste Signal (A) ist, wobei die Ausgänge anderenfalls 'niedrig' sind, und wobei die ersten, zweiten und dritten Ausgänge der Vergleichereinrichtungen der Schaltung als die zweiten (BIT 0), dritten (BIT 1) bzw. ersten (BIT 2) der binären Eingangssignale zugeführt werden.

3. Schaltung nach Anspruch 1, unter Einschluß von Einrichtungen zur Erzeugung eines Servopositions-Fehlersignals (SPE, S1) mit einer Sägezahnschwingungsform (WF1, WF4) aus den einen Abstand aufweisenden Dreiphasen-Signalen (A, B, C), mit einer ersten Analogschaltereinrichtung (U14₁), die als ihre Eingänge das zweite der einen Abstand aufweisenden Dreiphasen-Signale (B), die invertierte Form des ersten Ausganges der Vergleichereinrichtungen und den dritten Ausgang der Vergleichereinrichtungen aufweist, mit einer zweiten Analogschaltereinrichtung (U14₂), die als ihre Eingänge das dritte der einen Abstand aufweisenden Dreiphasen-Signale (C), die invertierte Form des ersten Ausganges der Vergleichereinrichtungen und den dritten Ausgang der Vergleichereinrichtungen aufweist, mit einer dritten Analogschaltereinrichtung (U14₃), die als ihre Eingänge das erste der einen Abstand aufweisenden Dreiphasen-Signale (A), den zweiten Ausgang der Vergleichereinrichtungen und die invertierte Form des dritten Ausganges der Vergleichereinrichtungen aufweist, mit einer vierten Analogschaltereinrichtung (U14₄), die als ihre Eingänge den zweiten Ausgang der Vergleichereinrichtungen, die invertierte Form des dritten Ausganges der Vergleichereinrichtungen und das zweite der einen Abstand aufweisenden Dreiphasen-Signale (B) aufweist, mit einer fünften Analogschaltereinrichtung (U14₅), die als ihre Eingänge das erste der einen Abstand aufweisenden Dreiphasen-Signale (A), den ersten Ausgang der Vergleichereinrichtungen und die invertierte Form des zweiten Ausganges der Vergleichereinrichtungen aufweist, mit einer sechsten Analogschalterein- richtung (U14₆), die als ihre Eingänge den ersten Ausgang der Vergleichereinrichtungen, die invertierte Form des zweiten Ausganges der Vergleichereinrichtungen und das dritte der einen Abstand aufweisenden Dreiphasen-Signale (C) aufweist, mit einer Differenzverstärkereinrichtung (U19), die an ihrem invertierenden Eingang die Ausgänge der ersten, dritten und sechsten Analogschaltereinrichtungen empfängt und die als ihren nichtnvertierenden Eingang die Ausgänge der zweiten, vierten und fünften der Analogschaltereinrichtungen empfängt, wobei der Ausgang der Differenzverstärkereinrichtung das Servopositions-Fehlersignal (SPE, S1) liefert.

4. Schaltung nach Anspruch 3, in Kombination mit einer zweiten Schaltung, um als ein Ausgangsspannungssignal (S2) zur Ansteuerung eines Servomechanismus eines Plattenlaufwerks das Differential des Servopositions-Fehlersignals (SPE, S1) zu liefern, wobei dieses Fehlersignal unerwünschte zeitliche Abschnitte aufweist, und wobei die zweite Schaltung folgende Teile umfaßt:
einen Eingangskondensator (C1), von dem eine Seite das Servopositions-Fehlersignal (SPE, S1) empfängt, während die andere Seite mit einem Schaltungsknoten (16) verbunden ist, der über zumindestens einen Widerstand (R2, R3) mit einem Eingangsanschluß eines Operationsverstärkers (U1-A) und mit einem Ende eines Rückführungswiderstandes (R4) verbunden ist, dessen anderes Ende mit dem Ausgangsanschluß des Operationsverstärkers (U1-A) und mit einer Ausgangsleitung (14) für das Ausgangssignal (S2) verbunden ist,
Einrichtungen (U1-B) zum Speichern der Spannung (V_{H}) an dem Schaltungsknoten (16) in einem Haltekondensator (C5), und
einen Schalter (SW), der auf das impulsförmige Ausgangssignal anspricht, um die Spannung (V_{H}) an dem Haltekondensator (C5) an den Knoten (16) für die Dauer der Impulse anzulegen, wobei die Impulse mit demjenigen Teil der Sägezahnschwingungsform (WF₁, WF₄) des Servopositions-Fehlersignals (SPE, S1) zusammenfallen, der die höchste Änderungsgeschwindigkeit aufweist, wobei diese Teile der Schwingungsform unerwünschte Zeitabschnitte sind.

5. Schaltung nach Anspruch 4,
dadurch gekennzeichnet, daß sie eine aktive Schaltungseinrichtung (U1-B) umfaßt, die zwischen dem Haltekondensator (C5) und dem Knoten (16) eingeschaltet ist, wobei die aktive Schaltungseinrichtung (U1-B) einen eine hohe Impedanz aufweisenden Eingang aufweist, der mit dem Haltekondensator (C5) verbunden ist, wodurch der Knoten (16) auf der Spannung (V_{H}) gehalten werden kann, ohne den Haltekondensator zu entladen.

6. Schaltung nach Anspruch 5,
dadurch gekennzeichnet, daß die aktive Schaltungseinrichtung (U1-B) ein Operationsverstärker ist.

7. Schaltung nach Anspruch 5 oder 6,
gekennzeichnet durch einen invertierenden Verstärker (U2), der zwischen dem Ausgang der aktiven Schaltungseinrichtung (U1-B) und dem Schaltungsknoten (16) und mit einem weiteren Eingang der aktiven Schaltungseinrichtung (U1-B) gekoppelt ist.

8. Schaltung nach Anspruch 5,
dadurch gekennzeichnet, daß die Einrichtungen zum Speichern der Spannung (V_{H}) an dem Schaltungsknoten (16) an dem Haltekondensator (C5) die aktive Schaltungseinrichtung (U1-B) umfassen.

## Revendications

1. Circuit pour fournir un signal impulsionnel (SIGNAL RESET) à partir de trois signaux d'entrée binaires (BIT 2, BIT 0, BIT 1), le circuit comprenant :
- des moyens pour inverser chacun desdits signaux d'entrée binaires (BIT 2, BIT 0, BIT 1),
- une première porte NON-OU (N1) ayant pour entrées l'inverse d'un premier signal (BIT 2) desdits signaux binaires et un troisième signal (BIT 1) desdits signaux binaires,
- une deuxième porte NON-OU (N2) ayant pour entrées le premier signal (BIT 2) desdits signaux binaires et l'inverse d'un deuxième signal (BIT 0) desdits signaux binaires,
- une troisième porte NON-OU (N3) ayant pour entrées le deuxième signal (BIT 0) desdits signaux d'entrée binaires et l'inverse du troisième signal (BIT 1) desdits signaux binaires,
- une première, deuxième, et troisième bascules (F4, F5, F6) qui reçoivent en tant qu'entrées respectives d'horloge la sortie de la première, de la deuxième et de la troisième portes NON-OU (N1, N2, N3), l'entrée D de chaque bascule étant liée à un niveau de voltage "haut",
- une première porte NON-ET (NA1) ayant en tant qu'entrées les sorties Q̅ respectives de chacune desdites bascules (F4, F5, F6),
- des moyens pour inverser la sortie de ladite porte NON-ET (NA1),
- une quatrième bascule (F7) ayant en tant qu'entrée C̅L̅E̅A̅R̅ l'inverse de la sortie de ladite première porte NON-ET (NA1) et en tant qu'entrée d'horloge une première impulsion d'horloge (CLOCK 1), et fournissant en tant que sortie Q le signal de sortie impulsionnel (SIGNAL RESET),
- une quatrième porte NON-OU (N4) ayant en tant qu'entrées la sortie Q de ladite quatrième bascule (F7) et l'inverse d'un deuxième signal d'horloge retardé (CLOCK 2),
- une cinquième bascule (F8) ayant en tant qu'entrée d'horloge la sortie de ladite quatrième porte NON-OU, en tant qu'entrée C̅L̅E̅A̅R̅ l'inverse de la sortie de ladite première porte NON-ET (NA1) et en tant qu'entrée D le niveau de voltage "haut", et ayant sa sortie Q appliquée à l'entrée D de ladite quatrième bascule (F7),
- et une deuxième porte NON-ET (NA2) ayant en tant qu'entrées ledit deuxième signal d'horloge retardé (CLOCK 2), la sortie Q̅ de ladite cinquième bascule (F8), la sortie Q de ladite quatrième bascule (F7), et la sortie de ladite première porte NON-ET (NA1), et ayant sa sortie appliquée à l'entrée C̅L̅E̅A̅R̅ de la première, deuxième et troisième bascules (F4, F5, F6).

2. Circuit selon la revendication 1 pour utilisation dans un système d'asservissement de lecteur de disques, incluant :
des moyens comparateurs (U8₁-U8₃) ayant en tant qu'entrée trois signaux espacés de manière triphasée (A, B, C) dérivés des motifs d'asservissement triphasés sur un disque magnétique et produisant une première sortie qui est à l'état "haut" si un premier desdits signaux espacés de manière triphasée (A) est plus grand qu'un deuxième (B), une deuxième sortie qui est à l'état "haut" si le deuxième desdits signaux espacés de manière triphasée (B) est plus grand qu'un troisième (C), et une troisième sortie qui est à l'état "haut" si le troisième desdits signaux espacés de manière triphasée (C) est plus grand que le premier (A), les sorties étant autrement au niveau "bas", la première, la deuxième et la troisième sorties des moyens comparateurs étant appliquées audit circuit respectivement en tant que deuxième (BIT 0), troisième (BIT 1) et premier (BIT 2) desdits signaux d'entrée binaires.

3. Circuit selon la revendication 2 incluant des moyens pour générer un signal d'erreur de position d'asservissement (SPE, S1) en forme de dent de scie (WF₁, WF₄) à partir desdits signaux espacés de manière triphasée (A, B, C), qui comprennent des moyens d'inversion (U1₁-U1₃) pour fournir une forme inversée de chacune des sorties des moyens comparateurs ; le premier moyen de commutation analogique (U14₁) ayant en tant qu'entrées le deuxième desdits signaux espacés de manière triphasée (B), l'inverse de la première sortie des moyens comparateurs et la troisième sortie des moyens comparateurs ; le deuxième moyen de commutation analogique (U14₂) ayant en tant qu'entrées le troisième desdits signaux espacés de manière triphasée (C), l'inverse de la première sortie des moyens comparateurs et la troisième sortie des moyens comparateurs ; le troisième moyen de commutation analogique (U14₃) ayant en tant qu'entrées le premier desdits signaux espacés de manière triphasée (A), la deuxième sortie des moyens comparateurs et l'inverse de la troisième sortie des moyens comparateurs ; le quatrième moyen de commutation analogique (U14₄) ayant en tant qu'entrées la deuxième sortie desdits moyens comparateurs, l'inverse de la troisième sortie desdits moyens comparateurs et le deuxième desdits signaux espacés de manière triphasée (B); le cinquième moyen de commutation analogique (U14₅) ayant en tant qu'entrées le premier desdits signaux espacés de manière triphasée (A), la première sortie desdits moyens comparateurs et l'inverse de la deuxième sortie desdits moyens comparateurs ; le sixième moyen de commutation analogique (U14₆) ayant en tant qu'entrées la première sortie des moyens comparateurs, l'inverse de la deuxième sortie des moyens comparateurs et le troisième desdits signaux espacés de manière triphasée (C) ; des moyens d'amplification opérationnelle (U19) qui reçoivent en tant qu'entrée inverseuse les sorties du premier, troisième et sixième moyens de commutation analogique, et qui reçoivent en tant qu'entrée non-inverseuse les sorties des deuxième, quatrième, et cinquième desdits moyens de commutation analogiques, la sortie des moyens d'amplification opérationnelle fournissant le signal d'erreur de position d'asservissement (SPE, S1).

4. Circuit selon la revendication 3 en combinaison avec un deuxième circuit pour fournir en tant que signal de voltage de sortie (S2), pour piloter un mécanisme d'asservissement d'un lecteur de disques, le différentiel du signal d'erreur de position d'asservissement (SPE, S1), ce signal d'erreur incluant des portions temporaires non-désirées, le deuxième circuit comprenant :
- une capacité d'entrée (C1), dont une extrémité reçoit ledit signal d'erreur de position d'asservissement (SPE, S1), et dont l'autre extrémité est connectée à un noeud de circuit (16) qui est connecté par l'intermédiaire d'au moins une résistance (R2, R3) à une broche d'entrée d'un amplificateur opérationnel (U1-A) et à une extrémité d'une résistance d'asservissement (R4) dont l'autre extrémité est connectée à la broche de sortie de l'amplificateur opérationnel (U1-A) et à une ligne de sortie (14) pour le signal de sortie (S2);
- des moyens (U1-B) pour stocker le voltage V_{H} au noeud de circuit (16) dans une capacité de blocage (C5),
- et un commutateur (SW) réagissant audit signal impulsionnel de sortie pour appliquer le voltage V_{H} de la capacité de blocage (C5) au noeud (16) pendant les impulsions, les impulsions coïncidant avec la partie de l'onde en dent de scie (WF₁, WF₄) du signal d'erreur de position d'asservissement (SPE, S1)ayant le plus grand taux de changement, ces parties d'onde étant lesdites portions temporaires non souhaitées.

5. Circuit selon la revendication 4, caractérisé en ce qu'il comprend un moyen de circuit actif (U1-B) couplé entre la capacité de blocage (C5) et le noeud (16), le moyen de circuit actif (U1-B) ayant une entrée haute impédance connectée à la capacité de blocage (C5), le noeud (16) pouvant de ce fait être maintenu au voltage V_{H} sans décharger la capacité de blocage.

6. Circuit selon la revendication 5, caractérisé en ce que le moyen de circuit actif (U1-B) est un amplificateur opérationnel.

7. Circuit selon les revendications 5 ou 6, caractérisé par un amplificateur inverseur (U2) couplé entre la sortie du moyen de circuit actif (U1-B) et le noeud de circuit (16) et à une autre entrée du moyen de circuit actif (U1-B).

8. Circuit selon la revendication 5, caractérisé en ce que ledit moyen de stockage de voltage V_{H} au noeud de circuit (16) par la capacité de blocage (C5) comprend ledit moyen de circuit actif (U1-B).
